# FASCICULE DE BREVET EUROPEEN

(11) **EP 3 190 282 B1**
(45) Date de publication et mention de la délivrance du brevet: **28.11.2018**
(21) Numéro de dépôt: 17150197.6
(22) Date de dépôt: 03.01.2017
(51) Int. Cl.: F02C 7/268, F02C 7/32, H02M 7/00

(54) **ARCHITECTURE ÉLECTRIQUE D'UN AÉRONEF COMPRENANT UNE PLAQUE DE REFROIDISSEMENT**
ELEKTRISCHER AUFBAU EINES LUFTFAHRZEUGS MIT KÜHLPLATTE
ELECTRICAL ARCHITECTURE OF AN AIRCRAFT COMPRISING A COOLING PLATE

(30) Priorité: 11.01.2016 FR 1650198
(43) Date de publication de la demande: 12.07.2017
(73) Titulaire: Liebherr-Aerospace Toulouse SAS, 31200 Toulouse (FR)
(72) Inventeur: DEVANNEAUX, Vincent, 31300 TOULOUSE (FR); ABDELLI, Youcef, 31140 SAINT ALBAN (FR); BRODEAU, Pierre, 31400 TOULOUSE (FR)
(74) Mandataire: Gevers & Orès

(56) Documents cités:
- EP-A1- 2 884 615
- EP-A2- 1 921 741
- WO-A1-2013/054699
- US-B2- 9 227 725

## Description

### 1. Domaine technique de l'invention

L'invention concerne une architecture électrique d'un aéronef. En particulier, l'invention concerne une architecture électrique d'un hélicoptère bimoteur.

### 2. Arrière-plan technologique

Les aéronefs comprennent une grande variété de charges électriques devant être alimentées au cours des phases au sol de préparation du vol et durant le vol. Ces charges électriques sont alimentées par diverses électroniques de puissance qui ont pour fonction de traiter l'énergie électrique fournie par un réseau électrique de bord et de l'adapter aux caractéristiques d'entrée des différentes charges (courant, tension, puissance, etc.).

En général, chaque charge est pilotée par son électronique de puissance dédiée. En outre, un aéronef réunit une pluralité de sous-ensembles fonctionnels fournis par une multitude de fournisseurs différents. Chaque fournisseur conçoit donc l'électronique de puissance dédiée à la charge qu'il fournit.

Ces électroniques de puissance dédiées entrainent de par leur nombre et leur spécificité un coût important. En outre, elles impactent de manière non négligeable le poids total de l'aéronef, en particulier lorsque l'aéronef est un hélicoptère.

Les électroniques de puissances nécessitent en outre un refroidissement efficace pour éviter une baisse de performances, une dégradation ou un arrêt du fonctionnement. En effet, dans un aéronef, les températures peuvent atteindre des valeurs importantes en condition de vol, notamment dues aux moteurs de propulsion. Les solutions actuelles proposent de placer toutes les électroniques de puissance dans une zone dite « avionique » de l'aéronef, comprenant la plupart des équipements électroniques, électrique et informatique de l'aéronef, et comprenant généralement des systèmes de refroidissement (à air, liquide, etc.) adaptés pour ces équipements. Toutefois, les électroniques sont dans ce cas éloignées des charges qu'elles alimentent, ce qui engendre des réductions des performances électriques (notamment du fait de perturbations électromagnétiques accrues), la nécessité de câbles supplémentaires, un encombrement augmenté, etc.

Une architecture selon l'art antérieur est décrit dans le document EP 1921741 A2.

Les inventeurs ont donc cherché à optimiser l'alimentation des différentes charges électriques d'un aéronef et le refroidissement des électroniques associées. En particulier, les inventeurs ont réalisé que certaines charges sont utilisées uniquement au sol pour le démarrage de l'aéronef ou uniquement pour certaines phases du vol et qu'une nouvelle architecture électrique devrait permettre d'optimiser la gestion de l'énergie électrique à bord d'un aéronef. Les objectifs de réduction de consommation d'énergie ont également conduit les inventeurs à chercher des solutions pour réduire le coût et la consommation énergétique des aéronefs, notamment par réduction du poids des équipements qu'ils embarquent.

### 3. Objectifs de l'invention

L'invention vise à pallier au moins certains des inconvénients des architectures électriques d'aéronef connues.

En particulier, l'invention vise à fournir, dans au moins un mode de réalisation de l'invention, une architecture permettant de réduire le poids de l'aéronef.

L'invention vise aussi à fournir, dans au moins un mode de réalisation, une architecture permettant une réduction des coûts de l'aéronef, à la fois les coûts de fabrication que les coûts de l'exploitation de l'aéronef.

L'invention vise aussi à fournir, dans au moins un mode de réalisation de l'invention, une architecture électrique qui permet de réduire la consommation énergétique globale de l'aéronef.

L'invention vise aussi à fournir, dans au moins un mode de réalisation, une architecture électrique qui permet un refroidissement efficace des électroniques de puissance.

### 4. Exposé de l'invention

Pour ce faire, l'invention concerne une architecture électrique d'un aéronef comprenant au moins un moteur de propulsion, ladite architecture comprenant un réseau de bord électrique, et au moins un groupe de charges électriques comprenant une pluralité de charges dont au moins :
- un démarreur électrique d'un moteur de propulsion de l'aéronef,
- un compresseur d'un circuit de réfrigération à compression de vapeur alimenté par une électronique de puissance à partir du réseau de bord électrique,
caractérisée en ce que, pour chaque groupe de charges :
- ladite électronique de puissance du compresseur est reliée au démarreur électrique et configurée pour pouvoir l'alimenter de manière à permettre un démarrage dudit moteur de propulsion associé,
- elle comprend une plaque de refroidissement agencée de manière à permettre un échange thermique entre l'électronique de puissance et un fluide d'un circuit de réfrigération associé à un compresseur.

On entend par électronique de puissance un ensemble de composants électroniques permettant la mise en forme d'un courant électrique pour alimenter des équipements selon les spécifications d'alimentation de ces équipements.

La caractéristique technique selon laquelle l'électronique de puissance est reliée au démarreur électrique signifie que l'électronique de puissance a une connexion électrique directe ou indirecte avec le démarreur électrique. En particulier, cette liaison entre l'électronique de puissance et le démarreur électrique peut comprendre un ou plusieurs composants électroniques interposés entre l'électronique de puissance et le démarreur électrique, tel que par exemple un contacteur.

Une architecture selon l'invention permet donc de réduire le nombre d'équipements nécessaires pour alimenter plusieurs charges de l'aéronef. En particulier, l'électronique de puissance alimentant un compresseur d'un circuit de réfrigération est reliée au démarreur électrique de manière à lui fournir la puissance nécessaire au démarrage du moteur propulsif auquel il est associé. Le démarrage du moteur propulsif nécessite une importante puissance, mais cette puissance n'est nécessaire qu'au démarrage du moteur. Une fois le moteur propulsif démarré, le démarreur ne nécessite plus d'apport d'énergie électrique, et devient généralement un générateur électrique du fait du fonctionnement du moteur.

D'autre part, le compresseur d'un circuit de réfrigération peut être alimenté qu'en partie ou pas du tout pendant le démarrage du moteur propulsif. Ainsi, une fois le moteur propulsif démarré, l'électronique de puissance peut-être totalement dédiée à l'alimentation du compresseur.

L'invention permet ainsi de réduire le nombre d'équipements nécessaires dans l'aéronef: par rapport à l'art antérieur, l'équipement utilisé pour le démarrage du moteur et qui n'est plus utilisé ensuite (notamment durant le vol) est supprimé. L'utilisation d'une seule électronique de puissance au lieu d'une pour le compresseur et d'une pour le moteur permet la réduction du coût de l'aéronef, de son poids et de sa consommation énergétique.

En outre, l'agencement de l'électronique de puissance à proximité du compresseur permet de simplifier leur liaison (diminution de la longueur de câblage, réduction des perturbations électromagnétiques) et la plaque de refroidissement assure un refroidissement efficace grâce au fluide d'un circuit de réfrigération. L'électronique de puissance est ainsi à une température adaptée aux conditions de vol.

Avantageusement et selon l'invention, au moins une électronique de puissance est agencée au contact du compresseur qu'elle alimente, et en ce que la plaque de refroidissement est portée par ledit compresseur et agencée entre l'électronique de puissance et le compresseur de manière à permettre un échange thermique entre l'électronique de puissance et un fluide du circuit de réfrigération traversant ledit compresseur.

Selon cet aspect de l'invention, le compresseur et l'électronique de puissance forment un seul appareil, ce qui diminue l'encombrement, simplifie leur liaison électrique, et permet un refroidissement efficace grâce au fluide traversant le compresseur, en limitant les pertes de charge du fluide du circuit de refroidissement.

Avantageusement et selon l'invention, au moins un groupe de charge comprend au moins une charge électrique supplémentaire et l'électronique de puissance est reliée à cette charge et configurée pour pouvoir l'alimenter à partir du réseau de bord.

Selon cet aspect de l'invention, l'électronique de puissance est adaptée pour alimenter d'autres types de charges, notamment une charge nécessitant un fort apport de puissance dans un intervalle de temps court, par exemple un démarreur de groupe auxiliaire de puissance, etc. En particulier, l'électronique de puissance est adaptée pour alimenter des charges présentant différentes caractéristiques d'entrées (courant, tension, puissance, etc.).

Avantageusement et selon ce dernier aspect de l'invention, une charge électrique supplémentaire est un démarreur d'un groupe auxiliaire de puissance (aussi appelé APU pour *Auxiliary Power Unit* en anglais).

Comme les moteurs de propulsion, le groupe auxiliaire de puissance n'est généralement démarré qu'en préparation de la mise en vol, son démarreur ne nécessite donc une puissance électrique que ponctuellement : celle-ci peut donc être fournie via l'électronique de puissance.

Avantageusement et selon l'invention, pour chaque groupe de charges, ladite électronique de puissance du compresseur est reliée à chaque charge du groupe et configurée pour pouvoir les alimenter à partir du réseau de bord.

Avantageusement et selon l'invention, l'électronique de puissance d'un compresseur d'un groupe de charge est configurée pour alimenter séquentiellement les charges dudit groupe de charge.

Selon cet aspect de l'invention, l'électronique de puissance n'alimente qu'une seule charge à la fois, et les autres charges ne sont pas alimentées. Ainsi, l'électronique de puissance peut être dimensionnée pour pouvoir fournir au maximum la puissance électrique nécessaire à l'alimentation de la charge électrique nécessitant la puissance électrique la plus élevée.

De préférence, l'électronique de puissance est reliée aux différentes charges d'un groupe de charges via un organe intermédiaire d'aiguillage (par exemple un contacteur) permettant l'alimentation d'une charge de ce groupe de charges à la fois. Le contacteur peut être inclus dans l'électronique de puissance ou séparé.

Avantageusement, une architecture électrique selon l'invention comprend :
- un premier groupe de charges comprenant un premier démarreur électrique d'un premier moteur de propulsion et un premier compresseur d'un premier circuit de réfrigération alimenté par une première électronique de puissance, ladite première électronique de puissance étant reliée au premier démarreur, et
- un deuxième groupe de charges comprenant un deuxième démarreur électrique d'un deuxième moteur de propulsion et un deuxième compresseur d'un deuxième circuit de réfrigération alimenté par une deuxième électronique de puissance, ladite deuxième électronique de puissance étant reliée au deuxième démarreur.

Selon cet aspect de l'invention, l'architecture électrique peut remplacer une architecture de l'art antérieur comprenant généralement deux électroniques de puissance pour alimenter deux compresseurs et un équipement pour alimenter les deux démarreurs des moteurs de propulsion. Dans l'invention, chaque électronique de puissance fournit l'alimentation à un des démarreurs pour remplacer l'équipement supprimé.

Par exemple, une architecture électrique de l'art antérieur comprenant deux électroniques de puissance de lOkW chacune pour alimenter les deux compresseurs et une électronique de puissance de 20kW pour alimenter les deux démarreurs nécessitant lOkW chacun est avantageusement remplacée par une architecture selon l'invention dans laquelle seules les électroniques de puissance de lOkW sont conservées et configurées pour pouvoir alimenter chacune un démarreur.

Avantageusement et selon une première variante de l'invention, une première plaque de refroidissement est agencée de manière à permettre un échange thermique entre la première électronique de puissance et un fluide du premier circuit de réfrigération, et une deuxième plaque de refroidissement est agencée de manière à permettre un échange thermique entre la deuxième électronique de puissance et un fluide du deuxième circuit de réfrigération.

Selon cet aspect de l'invention, les circuits de réfrigération sont simples à mettre en oeuvre et peuvent être isolés l'un de l'autre. Dans cette variante de l'invention, si l'électronique de puissance est dans un environnement à température élevée, l'alimentation du démarreur entraine une augmentation importante de la température de l'électronique de puissance qui peut alors être endommagée faute de refroidissement du fait de la non-alimentation du compresseur. Pour éviter cela, l'électronique alimente le compresseur auquel elle est associée de sorte à être refroidie par le fluide du circuit de réfrigération, puis arrête ou réduit l'alimentation du compresseur pour alimenter le démarreur, puis alimente de nouveau le compresseur une fois démarré.

Un procédé d'alimentation de charges d'une architecture électrique de cette première variante comprend :
- une étape d'alimentation du premier compresseur par la première électronique de puissance et d'alimentation du deuxième compresseur par la deuxième électronique de puissance, de manière à réduire la température de chaque électronique de puissance,
- une étape d'alimentation du premier démarreur par la première électronique de puissance et d'alimentation du deuxième démarreur par la deuxième électronique de puissance,
- une étape d'alimentation du premier compresseur par la première électronique de puissance et d'alimentation du deuxième compresseur par la deuxième électronique de puissance.

Avantageusement et selon une deuxième variante de l'invention, une première plaque de refroidissement est agencée de manière à permettre un échange thermique entre la première électronique de puissance et un fluide du deuxième circuit de réfrigération, et une deuxième plaque de refroidissement est agencée de manière à permettre un échange thermique entre la deuxième électronique de puissance et un fluide du premier circuit de réfrigération.

Selon cet aspect de l'invention, les circuits de réfrigération sont en configuration croisée, le fluide d'un des circuits permettant le refroidissement de l'électronique de puissance de l'autre circuit. En effet, si lors de l'allumage de l'aéronef, une des électroniques de puissance est dédiée directement à l'alimentation d'un démarreur pour le démarrage d'un moteur propulsif, elle n'alimente pas le compresseur qui lui est associé et ne peut donc pas être rafraîchie par le fluide de ce circuit de réfrigération, car le circuit de réfrigération n'a pas été mis en marche.

Ainsi, dans cette variante, la deuxième électronique de puissance alimente le deuxième circuit de réfrigération de façon à refroidir la première électronique de puissance pendant l'allumage du premier moteur de propulsion, puis la première électronique de puissance alimente le premier circuit de réfrigération de façon à refroidir la deuxième électronique de puissance pendant l'allumage du deuxième moteur de propulsion.

Un procédé d'alimentation de charges d'une architecture électrique de cette deuxième variante comprend :
- une étape d'alimentation du premier démarreur par la première électronique de puissance et d'alimentation du deuxième compresseur par la deuxième électronique de puissance,
- une étape d'alimentation du deuxième démarreur par la deuxième électronique de puissance et d'alimentation du premier compresseur par la première électronique de puissance.

L'invention concerne également un hélicoptère, caractérisé en ce qu'il comprend une architecture électrique selon l'invention.

Un hélicoptère selon l'invention présente ainsi un coût, un poids et une consommation énergétique réduits par rapport à un hélicoptère de l'art antérieur, pour un fonctionnement similaire.

Avantageusement et selon l'invention, un groupe de charges comprend un treuil de l'hélicoptère et l'électronique de puissance est reliée au treuil et configurée pour pouvoir l'alimenter à partir du réseau de bord.

Selon cet aspect de l'invention, le treuil d'un hélicoptère, en particulier un moteur actionnant ce treuil, est une charge électrique qui n'est utilisée que ponctuellement pour déployer ou rétracter le treuil et donc peut-être alimentée par l'électronique de puissance du compresseur.

L'invention concerne également un procédé d'alimentation de charges d'une architecture électrique selon l'invention, caractérisé en ce qu'il comprend au moins une étape d'alimentation d'un compresseur par une électronique de puissance et au moins une étape d'alimentation d'un démarreur par ladite électronique de puissance.

L'invention concerne également une architecture électrique, un hélicoptère et un procédé d'alimentation caractérisés en combinaison par tout ou partie des caractéristiques mentionnées ci-dessus ou ci-après.

### 5. Liste des figures

D'autres buts, caractéristiques et avantages de l'invention apparaîtront à la lecture de la description suivante donnée à titre uniquement non limitatif et qui se réfère aux figures annexées dans lesquelles :
- la figure 1 est une vue schématique d'une architecture électrique selon un mode de réalisation de l'invention,
- la figure 2 est une vue schématique de deux électroniques de puissance et de deux compresseurs d'une architecture électrique selon un mode de réalisation de l'invention,
- la figure 3 est une vue schématique de deux circuits de réfrigération comprenant deux électroniques de puissance et de deux compresseurs d'une architecture électrique selon un premier mode de réalisation de l'invention,
- les figures 4a et 4b sont des vues schématiques de deux circuits de réfrigération comprenant deux électroniques de puissance et de deux compresseurs d'une architecture électrique selon un deuxième mode de réalisation de l'invention, dans deux étapes de fonctionnement.

### 6. Description détaillée d'un mode de réalisation de l'invention

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations. Sur les figures, les échelles et les proportions ne sont pas strictement respectées et ce, à des fins d'illustration et de clarté.

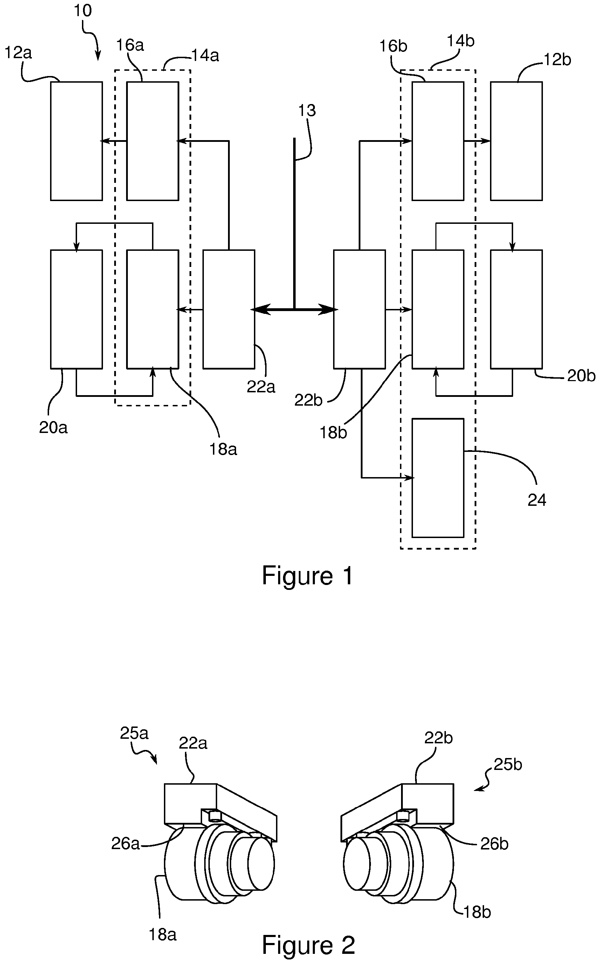

La figure 1 représente schématiquement une architecture 10 électrique d'un aéronef selon un mode de réalisation de l'invention. L'aéronef est un aéronef bimoteur, c'est-à-dire comprenant deux moteurs de propulsion, un premier moteur 12a de propulsion et un deuxième moteur 12b de propulsion, et un réseau 13 de bord électrique permettant la distribution d'énergie électrique aux équipements. Par exemple, l'aéronef peut être un hélicoptère comprenant deux turbomachines, et le réseau de bord distribue un courant alternatif de tension 115V.

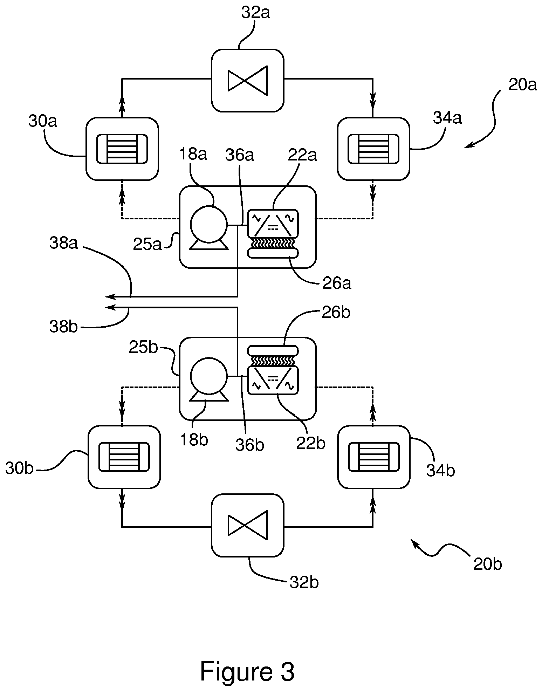

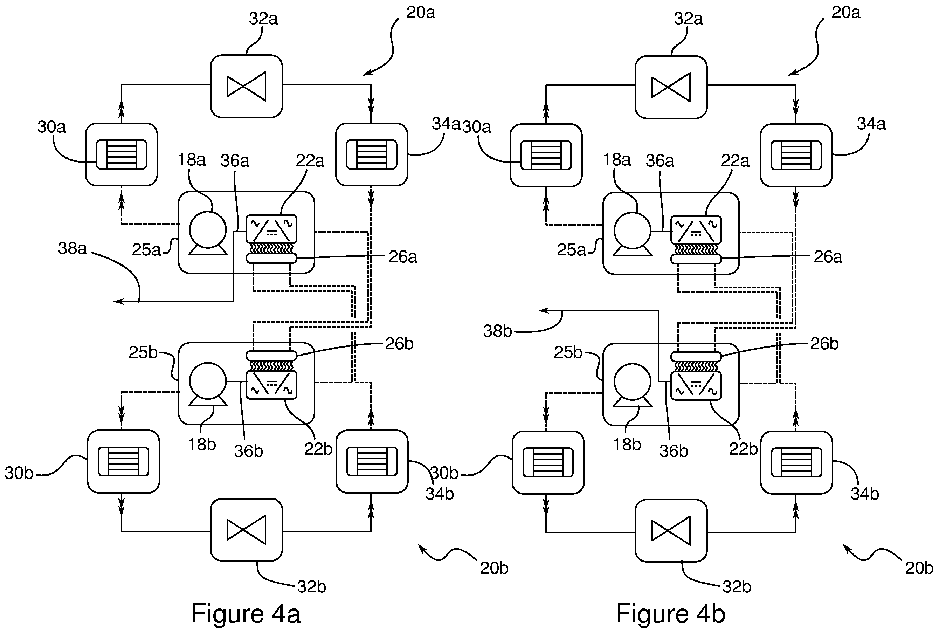

L'architecture 10 électrique comprend des groupes de charges, ici un premier groupe 14a de charges et un deuxième groupe 14b de charges, comprenant chacun une pluralité de charges. En particulier, chaque groupe de charge comprend au moins :
- un démarreur électrique d'un des deux moteurs de propulsion de l'aéronef, permettant d'entraîner le moteur propulsif en rotation pour le démarrer. Le démarreur électrique est généralement utilisé comme générateur électrique une fois le moteur propulsif démarré.
- un compresseur d'un circuit de réfrigération à compression de vapeur (ou VCS pour *Vapor Cooling System* en anglais). Le circuit de réfrigération comprend aussi des échangeurs thermiques et un détendeur, représentés et décrits ci-après en référence avec les figures 3, 4a et 4b. Le circuit de réfrigération permet de rafraîchir de l'air via un échangeur, l'air rafraîchi pouvant être utilisé pour refroidir des équipements de l'aéronef, ou être utilisé pour le conditionnement d'air de la cabine de pilotage ou des passagers. En outre, le fluide du circuit de réfrigération est utilisé pour refroidir une électronique de puissance via une plaque de refroidissement, comme décrit plus loin en référence avec les figures 2, 3, 4a et 4b.

En particulier, dans le mode de réalisation représenté sur la figure 1, le premier groupe 14a de charges comprend un premier démarreur 16a électrique du premier moteur 12a de propulsion et un premier compresseur 18a d'un premier circuit 20a de réfrigération, et le deuxième groupe 14b de charges comprend un deuxième démarreur 16b électrique du deuxième moteur 12b de propulsion et un deuxième compresseur 18b d'un deuxième circuit 20b de réfrigération.

Les deux compresseurs sont chacun alimentés, de façon connue, par une électronique de puissance à partir du courant électrique distribué par le réseau 13 de bord. L'électronique de puissance effectue une mise en forme (par exemple une conversion du courant) du courant du réseau de bord pour l'adapter aux spécifications du compresseur auquel elle est associée.

Le premier compresseur 18a est alimenté par une première électronique 22a de puissance et le deuxième compresseur 18b est alimenté par une deuxième électronique 22b de puissance.

Dans l'architecture 10 électrique, les électroniques de puissance sont aussi reliées aux démarreurs, et sont configurées pour pouvoir alimenter ces démarreurs : la première électronique 22a de puissance est reliée au premier démarreur 16a et la deuxième électronique 22b de puissance est reliée au deuxième démarreur 16b.

L'alimentation des démarreurs par les électroniques de puissance permet ainsi le démarrage des moteurs de propulsion.

Les groupes de charges peuvent aussi comprendre des charges supplémentaires. Ainsi, dans ce mode de réalisation, le deuxième groupe 14b de charges comprend une charge 24 supplémentaire qui peut être par exemple un groupe auxiliaire de puissance ou, lorsque l'aéronef est un hélicoptère, un treuil de l'hélicoptère. Dans ce cas, chaque électronique de puissance est reliée aux charges du groupe de charge auquel elle est associée et est configurée pour alimenter les charges dudit groupe de charge.

La figure 2 représente deux compresseurs et leurs électroniques de puissance associées selon un mode de réalisation de l'invention.

Dans ce mode de réalisation, chaque électronique de puissance est agencée au contact du compresseur auquel elle est associée de sorte à former un seul appareil. Le compresseur porte une plaque de refroidissement agencée pour un échange thermique entre l'électronique de puissance et un fluide du circuit de réfrigération traversant le compresseur : la première électronique 22a de puissance est au contact d'une première plaque 26a de refroidissement portée par le premier compresseur 18a, formant un premier appareil 25a et la deuxième électronique 22b de puissance est au contact d'une deuxième plaque 26b de refroidissement portée par le deuxième compresseur 18b, formant un deuxième appareil 25b.

Selon d'autres modes de réalisation non représentée, l'électronique de puissance peut être légèrement déportée du compresseur, tout en restant à proximité du circuit de réfrigération associé audit compresseur de sorte à permettre un échange thermique entre le fluide du circuit et l'électronique de puissance via une plaque de refroidissement. Notamment, la plaque de refroidissement peut être disposée en amont d'un compresseur de sorte à permettre l'échange thermique avec le fluide (par exemple du fréon) dudit circuit de réfrigération avant son réchauffement lors de la compression par le compresseur.

Le fluide utilisé pour l'échange thermique provient, selon les modes de réalisation, d'un des deux circuits de réfrigération en fonction de la configuration de ces circuits, comme décrit ci-dessous en référence aux figures 3, 4a et 4b

L'échange thermique entre l'électronique de puissance et le fluide d'un circuit de réfrigération permet le fonctionnement de l'électronique de puissance à une température très favorable : par exemple, dans un hélicoptère, même si la température dans la zone où se situe le circuit de réfrigération est généralement proche des 105°C en condition de vol, l'échange thermique permet d'abaisser la température pour atteindre approximativement 55°C au niveau des plaques de refroidissement, permettant ainsi le fonctionnement des électroniques de puissance sans risques de dégradations dues à des surchauffes.

Les figures 3, 4a et 4b représentent schématiquement deux compresseurs et deux circuits de réfrigération d'une architecture selon un premier et un deuxième mode de réalisation.

Le premier circuit 20a de réfrigération permet la circulation d'un fluide réfrigérant (par exemple du fréon) et comprend :
- un premier appareil 25a formé du premier compresseur 18a, de la première électronique 22a de puissance et de la première plaque 26a de refroidissement. Sur la figure, le compresseur, l'électronique de puissance et la plaque de refroidissement sont représentés séparés, mais peuvent être en contact l'un de l'autre comme dans le mode de réalisation décrit précédemment en référence à la figure 2. Le premier compresseur 18a permet la compression du fluide de refroidissement.
- un échangeur thermique dit premier condenseur 30a, permettant la condensation du fluide de refroidissement.
- un premier détendeur 32a, permettant la détente du fluide de refroidissement.
- un échangeur thermique dit premier évaporateur 34a, permettant l'évaporation du fluide de refroidissement en absorbant la chaleur au niveau du premier évaporateur, entrainant ainsi une baisse de température d'air circulant à travers lui.

De la même façon, le deuxième circuit 20b de réfrigération comprend un deuxième appareil 25b formé du deuxième 18b compresseur, de la deuxième électronique 22b de puissance et de la deuxième plaque 26b de refroidissement, un deuxième condenseur 30b, un deuxième détendeur 32b et un deuxième évaporateur 34b.

L'électronique de puissance peut alimenter une pluralité de charges d'un groupe de charge, notamment le compresseur ou le démarreur. Lorsque l'alimentation est séquentielle, c'est-à-dire que l'électronique alimente une seule charge à un instant donné, la sélection de la charge alimentée peut se faire grâce à une commande : sur les figures 3, 4a et 4b, une première commande permet à la première électronique 22a de puissance, via un contacteur 36a, l'alimentation du premier compresseur 18a ou l'alimentation du premier démarreur (représentée ici par la flèche 38a), et une deuxième commande permet à la deuxième électronique 22b de puissance, via un contacteur 36b, l'alimentation du deuxième compresseur 18b ou l'alimentation du deuxième démarreur (représentée ici par la flèche 38b).

La figure 3 représente une première configuration des circuits de réfrigération, dans laquelle les deux circuits de réfrigération sont séparés l'un de l'autre. Dans cette configuration, lors de la mise en marche de l'aéronef en vue d'enclencher une phase de vol, aucune charge n'est alimentée donc les circuits de réfrigération ne sont pas fonctionnels. Les électroniques de puissance ne sont donc pas refroidies par les plaques de refroidissement. Si la température environnante des électroniques de puissance est trop élevée et si les électroniques de puissance sont utilisées directement pour alimenter les démarreurs des moteurs, celles-ci peuvent être endommagées du fait d'une chauffe trop importante, car le démarrage du moteur nécessite une puissance importante dans un intervalle de temps court, ce qui augmente la température de l'électronique de puissance.

Ainsi, dans cette configuration, les compresseurs des circuits de réfrigération sont alimentés préalablement à tout démarrage des moteurs, de sorte à abaisser la température des fluides de réfrigération et donc des électroniques de puissance via les plaques de refroidissement. Une fois une température acceptable atteinte (généralement inférieure ou égale à 55°C), les électroniques de puissance stoppent l'alimentation des compresseurs et alimentent les démarreurs afin de démarrer les moteurs de propulsion. Une fois les moteurs démarrés, les électroniques de puissance stoppent l'alimentation des démarreurs et reprennent l'alimentation des compresseurs.

Plus généralement, dans cette première configuration de circuit de réfrigération, en cas d'alimentation d'une charge d'un groupe de charge différente du compresseur, la température de l'électronique de puissance doit être contrôlée et le compresseur de ce groupe doit être alimenté préalablement si la température est trop élevée, pendant un temps suffisant pour atteindre une température acceptable. Cette première configuration est néanmoins simple à mettre en oeuvre.

Les figures 4a et 4b représentent une deuxième configuration des circuits de réfrigération respectivement dans une première et une deuxième étape de fonctionnement, dans laquelle les deux circuits de réfrigération sont reliés et en configuration dite croisée : le fluide d'un des circuits de réfrigération est utilisé pour l'échange thermique avec l'électronique de puissance reliée au compresseur de l'autre circuit de réfrigération.

Cette deuxième configuration permet de réduire le temps de démarrage des moteurs propulsifs lors de la mise en marche de l'aéronef en vue d'enclencher une phase de vol par rapport à la première configuration : pour éviter les risques de chauffe trop importante décrits précédemment, le démarrage des deux moteurs se fait en deux temps, représentés par les deux étapes de fonctionnement.

Dans la première étape, représentée en référence à la figure 4a, la première électronique 22a de puissance alimente le premier démarreur (représenté ici par la flèche 38a) et la deuxième électronique 22b de puissance alimente le deuxième compresseur 18b. Le fluide du deuxième circuit 20b de réfrigération circule, et permet un échange thermique avec la première plaque 26a de refroidissement de sorte à refroidir la première électronique 22a de puissance.

Dans la deuxième étape, représentée en référence à la figure 4b, la deuxième électronique 22b de puissance alimente le deuxième démarreur (représenté ici par la flèche 38b) et la première électronique 22a de puissance alimente le premier compresseur 18a. Le fluide du premier circuit 20a de réfrigération circule, et permet un échange thermique avec la deuxième plaque 26b de refroidissement de sorte à refroidir la deuxième électronique 22b de puissance.

Ces étapes sont aussi mises en oeuvre lors de l'alimentation d'une autre charge du groupe de charge par une des électroniques de puissance : l'autre électronique de puissance alimente le compresseur qui lui est associé pour éviter les risques de chauffe trop importante.

L'invention ne se limite pas aux modes de réalisation décrits. En particulier, selon d'autres modes de réalisation de l'invention, l'aéronef peut comprendre un seul moteur de propulsion (aéronef monomoteur) et un seul groupe de charges. En outre, un groupe de puissance peut comprendre une électronique de puissance et deux démarreurs de deux moteurs propulsifs ou davantage.

## Revendications

1. Architecture électrique d'un aéronef comprenant au moins un moteur (12a, 12b) de propulsion, ladite architecture comprenant un réseau (13) de bord électrique, et au moins un groupe (14a, 14b) de charges électriques comprenant une pluralité de charges électriques dont au moins :
- un démarreur (16a, 16b) électrique d'un moteur (12a, 12b) de propulsion de l'aéronef,
- un compresseur (18a, 18b) d'un circuit (20a, 20b) de réfrigération à compression de vapeur alimenté par une électronique (22a, 22b) de puissance à partir du réseau (13) de bord électrique,
**caractérisée en ce que**, pour chaque groupe (14a, 14b) de charges :
ladite électronique (22a, 22b) de puissance du compresseur (18a, 18b) est reliée au démarreur (16a, 16b) électrique et configurée pour pouvoir l'alimenter de manière à permettre un démarrage dudit moteur (12a, 12b) de propulsion associé, et
elle comprend une plaque (26a, 26b) de refroidissement agencée de manière à permettre un échange thermique entre l'électronique (22a, 22b) de puissance et un fluide d'un circuit (20a, 20b) de réfrigération associé à un compresseur.

2. Architecture électrique selon la revendication 1, **caractérisée en ce qu'**au moins une électronique (22a, 22b) de puissance est agencée au contact du compresseur (18a, 18b) qu'elle alimente, et **en ce que** la plaque (26a, 26b) de refroidissement est portée par ledit compresseur (18a, 18b) et agencée entre l'électronique (22a, 22b) de puissance et le compresseur (18a, 18b) de manière à permettre un échange thermique entre l'électronique (22a, 22b) de puissance et un fluide du circuit (20a, 20b) de réfrigération traversant ledit compresseur.

3. Architecture électrique selon l'une des revendications 1 ou 2, **caractérisée en ce qu'**au moins un groupe (14a, 14b) de charge comprend au moins une charge électrique supplémentaire (24) et l'électronique (22a, 22b) de puissance est reliée à cette charge et configurée pour pouvoir l'alimenter à partir du réseau (13) de bord.

4. Architecture électrique selon la revendication 3, **caractérisée en ce qu'**une charge électrique supplémentaire est un démarreur d'un groupe auxiliaire de puissance.

5. Architecture électrique selon l'une des revendications 1 à 4, **caractérisée en ce que** l'électronique (22a, 22b) de puissance d'un compresseur (18a, 18b) d'un groupe (14a, 14b) de charge est configurée pour alimenter séquentiellement les charges dudit groupe (14a, 14b) de charge.

6. Architecture électrique selon l'une des revendications 1 à 5, **caractérisée en ce qu'**elle comprend :
- un premier groupe (14a) de charges comprenant un premier démarreur (16a) électrique d'un premier moteur (12a) de propulsion et un premier compresseur (18a) d'un premier circuit (20a) de réfrigération alimenté par une première (22a) électronique de puissance, ladite première électronique (22a) de puissance étant reliée au premier démarreur (16a), et
- un deuxième groupe (14b) de charges comprenant un deuxième démarreur (16b) électrique d'un deuxième moteur (12b) de propulsion et un deuxième compresseur (18b) d'un deuxième circuit (20b) de réfrigération alimenté par une deuxième électronique (22b) de puissance, ladite deuxième électronique (22b) de puissance étant reliée au deuxième démarreur (16b).

7. Architecture électrique selon la revendication 6, **caractérisée en ce qu'**une première plaque (26a) de refroidissement est agencée de manière à permettre un échange thermique entre la première électronique (22a) de puissance et un fluide du premier circuit (20a) de réfrigération, et **en ce qu'**une deuxième plaque (26b) de refroidissement est agencée de manière à permettre un échange thermique entre la deuxième électronique (22b) de puissance et un fluide du deuxième circuit (20b) de réfrigération.

8. Architecture électrique selon la revendication 6, **caractérisée en ce qu'**une première plaque (26a) de refroidissement est agencée de manière à permettre un échange thermique entre la première électronique (22a) de puissance et un fluide du deuxième circuit (20b) de réfrigération, et **en ce qu'**une deuxième plaque (26b) de refroidissement est agencée de manière à permettre un échange thermique entre la deuxième électronique (22b) de puissance et un fluide du premier circuit (20a) de réfrigération.

9. Hélicoptère, **caractérisé en ce qu'**il comprend une architecture (10) électrique selon une des revendications 1 à 8.

10. Hélicoptère selon la revendication 9, **caractérisé en ce qu'**un groupe (14b) de charges comprend un treuil (24) de l'hélicoptère et l'électronique (22b) de puissance est reliée au treuil (24) et configurée pour pouvoir l'alimenter à partir du réseau (13) de bord.

11. Procédé d'alimentation de charges d'une architecture (10) électrique telle que définie selon la revendication 7, **caractérisé en ce qu'**il comprend successivement :
- une étape d'alimentation du premier compresseur (18a) par la première électronique (22a) de puissance et d'alimentation du deuxième compresseur (18b) par la deuxième électronique (22b) de puissance, de manière à réduire la température de chaque électronique (22a, 22b) de puissance,
- une étape d'alimentation du premier démarreur (16a) par la première électronique (22a) de puissance et d'alimentation du deuxième démarreur (16b) par la deuxième électronique (22b) de puissance,
- une étape d'alimentation du premier compresseur (18a) par la première électronique (22a) de puissance et d'alimentation du deuxième compresseur (18b) par la deuxième électronique (22b) de puissance.

12. Procédé d'alimentation de charges d'une architecture (10) électrique telle que définie selon la revendication 8, **caractérisé en ce qu'**il comprend successivement :
- une étape d'alimentation du premier démarreur (16a) par la première électronique (22a) de puissance et d'alimentation du deuxième compresseur (18b) par la deuxième électronique (22b) de puissance,
- une étape d'alimentation du deuxième démarreur (16b) par la deuxième électronique (22b) de puissance et d'alimentation du premier compresseur (18a) par la première électronique (22a) de puissance.

## Patentansprüche

1. Elektrischer Aufbau eines Luftfahrzeugs, umfassend mindestens einen Antriebsmotor (12a, 12b), wobei der Aufbau ein elektrisches Bordnetz (13) und mindestens eine elektrische Ladungsgruppe (14a, 14b) umfasst, die eine Vielzahl von elektrischen Ladungen umfasst, darunter mindestens:
- einen elektrischen Anlasser (16a, 16b) eines Antriebsmotors (12a, 12b) des Luftfahrzeugs,
- einen Verdichter (18a, 18b) eines Dampfverdichtungs-Kühlkreislaufs (20a, 20b), der durch eine Leistungselektronik (22a, 22b) ausgehend vom elektrischen Bordnetz (13) versorgt wird,
**dadurch gekennzeichnet, dass** für jede Ladungsgruppe (14a, 14b):
die Leistungselektronik (22a, 22b) des Verdichters (18a, 18b) an den elektrischen Anlasser (16a, 16b) angeschlossen und konfiguriert ist, um ihn so versorgen zu können, um ein Starten des zugehörigen Antriebsmotors (12a, 12b) zu ermöglichen, und
sie eine Kühlplatte (26a, 26b) umfasst, die so angeordnet ist, um einen Wärmeaustausch zwischen der Leistungselektronik (22a, 22b) und einer zu einem Verdichter zugehörigen Flüssigkeit eines Kühlkreislaufs (20a, 20b) zu ermöglichen.

2. Elektrischer Aufbau nach Anspruch 1, **dadurch gekennzeichnet, dass** mindestens eine Leistungselektronik (22a, 22b) im Kontakt mit dem Verdichter (18a, 18b), den sie versorgt, angeordnet ist, und dadurch, dass die Kühlplatte (26a, 26b) vom Verdichter (18a, 18b) getragen wird und so zwischen der Leistungselektronik (22a, 22b) und dem Verdichter (18a, 18b) angeordnet ist, um einen Wärmeaustausch zwischen der Leistungselektronik (22a, 22b) und einer Flüssigkeit des Kühlkreislaufs (20a, 20b), die den Verdichter durchquert, zu ermöglichen.

3. Elektrischer Aufbau nach einem der Ansprüche 1 oder 2, **dadurch gekennzeichnet, dass** mindestens eine Ladungsgruppe (14a, 14b) mindestens eine zusätzliche elektrische Ladung (24) umfasst und die Leistungselektronik (22a, 22b) an diese Ladung angeschlossen und konfiguriert ist, um sie ausgehend vom Bordnetz (13) versorgen zu können.

4. Elektrischer Aufbau nach Anspruch 3, **dadurch gekennzeichnet, dass** eine zusätzliche elektrische Ladung ein Anlasser einer Leistungs-Hilfsgruppe ist.

5. Elektrischer Aufbau nach einem der Ansprüche 1 bis 4, **dadurch gekennzeichnet, dass** die Leistungselektronik (22a, 22b) eines Verdichters (18a, 18b) einer Ladungsgruppe (14a, 14b) konfiguriert ist, um die Ladungen der Ladungsgruppe (14a, 14b) sequentiell zu versorgen.

6. Elektrischer Aufbau nach einem der Ansprüche 1 bis 5, **dadurch gekennzeichnet, dass** er umfasst:
- eine erste Ladungsgruppe (14a), umfassend einen ersten elektrischen Anlasser (16a) eines ersten Antriebsmotors (12a) und einen ersten Verdichter (18a) eines ersten Kühlkreislaufs (20a), der durch eine erste Leistungselektronik (22a) versorgt wird, wobei die erste Leistungselektronik (22a) an den ersten Anlasser (16a) angeschlossen ist, und
- eine zweite Ladungsgruppe (14b), umfassend einen zweiten elektrischen Anlasser (16b) eines zweiten Antriebsmotors (12b) und einen zweiten Verdichter (18b) eines zweiten Kühlkreislaufs (20b), der durch eine zweite Leistungselektronik (22b) versorgt wird, wobei die zweite Leistungselektronik (22b) an den zweiten Anlasser (16b) angeschlossen ist.

7. Elektrischer Aufbau nach Anspruch 6, **dadurch gekennzeichnet, dass** eine erste Kühlplatte (26a) so angeordnet ist, um einen Wärmeaustausch zwischen der ersten Leistungselektronik (22a) und einer Flüssigkeit des ersten Kühlkreislaufs (20a) zu ermöglichen, und dadurch, dass eine zweite Kühlplatte (26b) so angeordnet ist, um einen Wärmeaustausch zwischen der zweiten Leistungselektronik (22b) und einer Flüssigkeit des zweiten Kühlkreislaufs (20b) zu ermöglichen.

8. Elektrischer Aufbau nach Anspruch 6, **dadurch gekennzeichnet**, das eine erste Kühlplatte (26a) so angeordnet ist, um einen Wärmeaustausch zwischen der ersten Leistungselektronik (22a) und einer Flüssigkeit des zweiten Kühlkreislaufs (20b) zu ermöglichen, und dadurch, dass eine zweite Kühlplatte (26b) so angeordnet ist, um einen Wärmeaustausch zwischen der zweiten Leistungselektronik (22b) und einer Flüssigkeit des ersten Kühlkreislaufs (20a) zu ermöglichen.

9. Hubschrauber, **dadurch gekennzeichnet, dass** er einen elektrischen Aufbau (10) nach einem der Ansprüche 1 bis 8 umfasst.

10. Hubschrauber nach Anspruch 9, **dadurch gekennzeichnet, dass** eine Ladungsgruppe (14b) eine Winde (24) des Hubschraubers umfasst, und die Leistungselektronik (22b) an die Winde (24) angeschlossen und konfiguriert ist, um diese ausgehend vom Bordnetz (13) versorgen zu können.

11. Verfahren zur Versorgung von Ladungen eines elektrischen Aufbaus (10) nach Anspruch 7, **dadurch gekennzeichnet, dass** es aufeinanderfolgend umfasst:
- einen Schritt der Versorgung des ersten Verdichters (18a) durch die erste Leistungselektronik (22a) und der Versorgung des zweiten Verdichters (18b) durch die zweite Leistungselektronik (22b), um die Temperatur jeder Leistungselektronik (22a, 22b) zu senken,
- einen Schritt der Versorgung des ersten Anlassers (16a) durch die erste Leistungselektronik (22a) und der Versorgung des zweiten Anlassers (16b) durch die zweite Leistungselektronik (22b),
- einen Schritt der Versorgung des ersten Verdichters (18a) durch die erste Leistungselektronik (22a) und der Versorgung des zweiten Verdichters (18b) durch die zweite Leistungselektronik (22b).

12. Verfahren zur Versorgung von Ladungen eines elektrischen Aufbaus (10) nach Anspruch 8, **dadurch gekennzeichnet, dass** es aufeinanderfolgend umfasst:
- einen Schritt der Versorgung des ersten Anlassers (16a) durch die erste Leistungselektronik (22a) und der Versorgung des zweiten Verdichters (18b) durch die zweite Leistungselektronik (22b),
- einen Schritt der Versorgung des zweiten Anlassers (16b) durch die zweite Leistungselektronik (22b) und der Versorgung des ersten Verdichters (18a) durch die erste Leistungselektronik (22a).

## Claims

1. Electrical architecture of an aircraft comprising at least one propulsion engine (12a, 12b), said architecture comprising an on-board electrical network (13), and at least one group (14a, 14b) of electrical loads comprising a plurality of electrical loads including at least:
- an electric starter (16a, 16b) of a propulsion engine (12a, 12b) of the aircraft,
- a compressor (18a, 18b) of a vapour compression cooling circuit (20a, 20b) supplied by power electronics (22a, 22b) from the on-board electrical network (13),
**characterised in that**, for each group (14a, 14b) of loads:
said power electronics (22a, 22b) of the compressor (18a, 18b) are connected to the electric starter (16a, 16b) and configured to be able to supply it so as to enable starting of said associated propulsion engine (12a, 12b), and
it comprises a cooling plate (26a, 26b) arranged so as to enable heat exchange between the power electronics (22a, 22b) and a fluid of a cooling circuit (20a, 20b) associated with a compressor.

2. Electrical architecture according to claim 1, **characterised in that** at least one item of power electronics (22a, 22b) is arranged in contact with the compressor (18a, 18b) that it supplies, and **in that** the cooling plate (26a, 26b) is carried by said compressor (18a, 18b) and arranged between the power electronics (22a, 22b) and the compressor (18a, 18b) so as to enable heat exchange between the power electronics (22a, 22b) and a fluid of the cooling circuit (20a, 20b) crossing said compressor.

3. Electrical architecture according to one of claims 1 or 2, **characterised in that** at least one load group (14a, 14b) comprises at least one additional electrical load (24) and the power electronics (22a, 22b) are connected to this load and configured to be able to supply it from the on-board network (13).

4. Electrical architecture according to claim 3, **characterised in that** an additional electrical load is a starter of an auxiliary power unit.

5. Electrical architecture according to one of claims 1 to 4, **characterised in that** the power electronics (22a, 22b) of a compressor (18a, 18b) of a load group (14a, 14b) is configured to sequentially supply the loads of said load group (14a, 14b).

6. Electrical architecture according to one of claims 1 to 5, **characterised in that** it comprises:
- a first group (14a) of loads comprising a first electric starter (16a) of a first propulsion engine (12a) and a first compressor (18a) of a first cooling circuit (20a) supplied by a first item of power electronics (22a), said first item of power electronics (22a) being connected to the first starter (16a), and
- a second group (14b) of loads comprising a second electric starter (16b) of a second propulsion engine (12b) and a second compressor (18b) of a second cooling circuit (20b) supplied by a second item of power electronics (22b), said second item of power electronics (22b) being connected to the second starter (16b).

7. Electrical architecture according to claim 6, **characterised in that** a first cooling plate (26a) is arranged so as to enable heat exchange between the first item of power electronics (22a) and a fluid of the first cooling circuit (20a), and **in that** a second cooling plate (26b) is arranged so as to enable heat exchange between the second item of power electronics (22b) and a fluid of the second cooling circuit (20b).

8. Electrical architecture according to claim 6, **characterised in that** a first cooling plate (26a) is arranged so as to enable heat exchange between the first item of power electronics (22a) and a fluid of the second cooling circuit (20b), and **in that** a second cooling plate (26b) is arranged so as to enable heat exchange between the second item of power electronics (22b) and a fluid of the first cooling circuit (20a).

9. Helicopter, **characterised in that** it comprises an electrical architecture (10) according to one of claims 1 to 8.

10. Helicopter according to claim 9, **characterised in that** a group (14b) of loads comprises a winch (24) of the helicopter and the power electronics (22b) are connected to the winch (24) and configured to be able to supply it from the on-board network (13).

11. Method for supplying loads of an electrical architecture (10) as defined according to claim 7, **characterised in that** it successively comprises:
- a step of supplying the first compressor (18a) by the first item of power electronics (22a) and supplying the second compressor (18b) by the second item of power electronics (22b), so as to reduce the temperature of each item of power electronics (22a, 22b),
- a step of supplying the first starter (16a) by the first item of power electronics (22a) and supplying the second starter (16b) by the second item of power electronics (22b),
- a step of supplying the first compressor (18a) by the first item of power electronics (22a) and supplying the second compressor (18b) by the second item of power electronics (22b).

12. Method for supplying loads of an electrical architecture (10) as defined according to claim 8, **characterised in that** it successively comprises:
- a step of supplying the first starter (16a) by the first item of power electronics (22a) and supplying the second compressor (18b) by the second item of power electronics (22b),
- a step of supplying the second starter (16b) by the second item of power electronics (22b) and supplying the first compressor (18a) by the first item of power electronics (22a).
